Europäisches Patentamt

European Patent Office

Office européen des brevets

(19)

(11) Veröffentlichungsnummer : **0 409 329 B1**

(12) **EUROPÄISCHE PATENTSCHRIFT**

(45) Veröffentlichungstag der Patentschrift :
**18.10.95 Patentblatt 95/42**

(51) Int. Cl.⁶ : **H03K 3/282, H03L 1/00**

(21) Anmeldenummer : **90201904.1**

(22) Anmeldetag : **13.07.90**

(54) Temperatur- und versorgungsspannungsunabhängige Multivibratorschaltung.

(30) Priorität : **19.07.89 DE 3923823**

(43) Veröffentlichungstag der Anmeldung :
**23.01.91 Patentblatt 91/04**

(45) Bekanntmachung des Hinweises auf die
Patenterteilung :
**18.10.95 Patentblatt 95/42**

(84) Benannte Vertragsstaaten :
**DE FR GB IT**

(56) Entgegenhaltungen :
**EP-A- 0 020 868**
**EP-A- 0 317 150**
**DD-A- 104 884**
**DE-C- 3 632 458**
**US-A- 3 725 681**
**PATENT ABSTRACTS OF JAPAN, Band 9, Nr.**
**197 (E-335)(1920), 14. August 1985; & JP - A -**
**6062724**

(73) Patentinhaber : **Philips Patentverwaltung**
**GmbH**
**Röntgenstrasse 24**
**D-22335 Hamburg (DE)**
㊄ **DE**
Patentinhaber : **Philips Electronics N.V.**
**Groenewoudseweg 1**
**NL-5621 BA Eindhoven (NL)**
㊄ **FR GB IT**

(72) Erfinder : **Pietrzyk, Michael**
**Georg-Wilhelm-Strasse 92a**
**D-2102 Hamburg 93 (DE)**

(74) Vertreter : **Peters, Carl Heinrich, Dipl.-Ing. et al**
**Philips Patentverwaltung GmbH,**
**Röntgenstrasse 24**
**D-22335 Hamburg (DE)**

## Beschreibung

Die Erfindung betrifft eine temperatur- und versorgungsspannungsunabhängige, emittergekoppelte Multivibratorschaltung.

Schaltungen eines in der Frequenz steuerbaren Oszillators, die im wesentlichen auf dem Funktionsprinzip des emittergekoppelten Multivibrators basieren und auf dem Gebiet der bipolaren integrierten Schaltungen, z.B. als spannungs- oder stromgesteuerter Oszillator (VCO oder CCO) und als Festoszillator in Phasenregelkreisen oder als Frequenzmodulator, Anwendung finden, sind aus den deutschen Patentschriften P 25 40 867 C2 und P 36 32 458 C2 bekannt.

Für die genannten Anwendungen sind insbesondere versorgungsspannungsunabhängige, driftfreie Schwingfrequenzen erwünscht. Für die gewünschte Driftfreiheit ist im wesentlichen erforderlich, daß der Ladestrom eines Kondensators und eine obere und eine untere Schwellenspannung, bei dessen Erreichen der Oszillator kippt, temperaturunabhängig sind oder deren Abhängigkeiten sich kompensieren.

Aus den genannten Patentschriften sind Möglichkeiten bekannt, die Frequenzdrift des emittergekoppelten Multivibrators zu vermindern. Beide bekannten Möglichkeiten weisen jedoch den Nachteil auf, daß sie entweder nicht gut für die Massenfertigung integrierter Schaltungen geeignet sind, oder aber überaus komplexe Netzwerke benötigen.

So geht aus der DE-PS 25 40 867 C2 eine temperaturkompensierte emittergekoppelte Multivibratorschaltung hervor, mit zwei Schalttransistoren, einem Zeitsteuerungskondensator zwischen den Emitterelektroden dieser Schalttransistoren, zwei Stromquellen, die zwischen den Emitterelektroden der Schalttransistoren und einem festen Potential geschaltet sind, wobei der gelieferte Strom durch eine Bezugsspannung gesteuert wird, wobei eine aufwendige Einrichtung zur Steuerung der Kollektorströme der Schalttransistoren derart vorgesehen ist, daß der Multivibrator kippt, wenn die Spannung über dem Zeitsteuerungskondensator im wesentlichen gleich der Sperrschichtspannung des Halbleiterübergangs bei einem Flußstrom ist, der gleich dem vorbestimmten Vielfachen eines von der ersten und zweiten Stromquelle gelieferten Stromes ist. Diese Schaltung weist ferner eine weitere aufwendige Einrichtung zur Erzeugung einer Bezugsspannung für die Stromquellen derart auf, daß die Bezugsspannung im wesentlichen gleich der Sperrschichtspannung des Halbleiterübergangs ist. Eine derartige Prinzipschaltung ist bereits überaus komplex. Sie wird jedoch noch aufwendiger, wenn eine Spannungssteuerung zur linearen Änderung der Frequenz des Multivibrators bei gleichem oder besserem Temperaturverhalten gewünscht wird. Eine entsprechende Schaltung ist dann auf eine Verringerung der temperaturbedingten Basisstromänderungen gerichtet, die aufgrund von temperaturbedingten Änderungen der Transistor-Stromverstärkungen auftreten. Als hierfür geeignete Prinzipien werden zwei Verfahren verwendet, nämlich die Verringerung des Transistor-Basisstromes durch Verwendung von Darlington-Transistoren und die Hinzufügung von Schaltungen zum Abziehen oder Zuführen eines temperaturabhängigen Stromes zum Kompensieren, der im wesentlichen gleich einem nachteiligen temperaturabhängigen Basisstrom ist.

Eine derartige Schaltung ist dann derart komplex, daß sie für Massenfertigung integrierter Schaltungen zwar noch geeignet, allerdings sehr aufwendig ist, weshalb Störungen zu befürchten sind.

Der Erfindung liegt die Aufgabe zugrunde, eine emittergekoppelte Multivibratorschaltung zu schaffen, zur Erzeugung einer steuerbaren Oszillatorfrequenz, die von Temperatur- und Versorgungsspannungsänderungen unabhängig ist, wenige Bauelemente aufweist und für die Massenfertigung in integrierter Schaltungstechnik gut geeignet ist.

Erfindungsgemäß wird diese Aufgabe bei einer gattungsgemäßen Multivibratorschaltung durch die Merkmale des unabhängigen Anspruchs gelöst.

Bei einer Oszillatorschaltung, bei der die Schalttransistoren emitterseitig über einen Kondensator verbunden sind und über je eine Stromquelle aus einem Transistor und einem Widerstand mit dem Massepol einer Versorgungsspannung verbunden sind, und ferner mit den Schalttransistoren kreuzgekoppelte Pegelschiebetransistoren aufweist, deren Kollektoren mit der Spannungsquelle und deren Emitter an je einer Basis der Schalttransistoren anliegen und weiter über je eine Stromquelle aus einem Transistor und einem Widerstand mit Masse verbunden sind, wobei die Basen der Stromquellentransistoren an einer Bezugsspannung anliegen, wird die Oszillatorfrequenz durch den Wert des Lade- und Entladestromes durch die Schalttransistoren und beispielsweise vorgeschalteten Widerständen, die Größe des Kondensators und einer vorgegebenen Differenz zwischen zwei Ansteuerungs- bzw. Schwellenspannungswerten zum Kippen des Oszillators nach der folgenden Gleichung bestimmt:

$$f = I_o/(2 U_H C) \quad (1)$$

Hierin ist $I_o$ die Größe des Entlade- bzw. Ladestromes, C die Kapazität des Kondensators und $U_H$ die zugelassene Differenz der Schwellenspannungswerte.

Für die Differenz $U_H$ der Schwellenspannungswerte läßt sich eine Näherungsbeziehung herleiten, die die Größe des Schwellenspannungswertes $U_H$ in Abhängigkeit von den Schaltungsparametern der Oszillatorschaltung angibt.

$$U_H \approx 2 R I_o - 2 U_T \ln (2 e R I_o/U_T) \quad (2)$$

Hierin ist R der Wert je eines Widerstandes der beispielsweise zwischen jedem Kollektor der Schalttransistoren und dem Pluspol der Versorgungsspannung geschaltet ist, e die Basis des Logarithmus naturalis und $U_T$ ergibt sich aus:

$$U_T = k\,T/q \quad (3)$$

Hierin ist k die Bolzmann-Konstante, T die Temperatur in Kelvin und q die elektrische Ladungseinheit.

Dies macht deutlich, daß die Oszillatorfrequenz bei temperaturunabhängigem Strom $I_o$ und temperaturunabhängigem Kondensator, was annähernd wohl auch der Fall ist, durch die Temperaturdrift der Differenz $U_H$ der Schwellenspannungswerte nach Gleichung (2) bestimmt wird und folglich nicht temperaturunabhängig ist.

Dadurch, daß die Schalttransistoren entsprechend den kennzeichnenden Merkmalen des Hauptanspruches nicht auf Widerstände, sondern aktive Lasten, insbesondere auf Transistoren der Stromsteuerschaltung arbeiten und die Emitterfläche des zweiten Transistors im Stromspiegelzweig um einen Faktor N größer ist als jede der gleichen Emitterflächen der kollektorseitig an der Spannungsquelle angeschlossenen ersten Abfangtransistoren, und daß die Emitterfläche des ersten Transistors im Stromspiegelzweig um einen Faktor P größer ist als jede der gleichen Emitterflächen der kollektorseitig gegen Masse geschalteten zweiten Abfangtransistoren, kann in vorteilhafter Weise eine Temperaturunabhängigkeit der Differenz $U_H$ des Schwellenspannungswertes erzeugt werden.

Besonders vorteilhaft ist es, wenn das Produkt der Faktoren N und P einem konstanten Wert, insbesondere einem Wert 11 entspricht, wodurch die Temperaturunabhängigkeit sichergestellt werden kann. Besonders vorteilhaft ist ferner, wenn der zweite Transistor im Stromspiegelzweig als Diode geschaltet ist und der erste Transistor eine Basis-Kollektor-Verbindung aufweist und die Stromquelle aus einem Transistor und einem Widerstand in Reihenschaltung aufgebaut ist, wobei der Widerstand an Masse anliegt und der Emitter des ersten Transistors mit der Spannungsquelle verbunden ist.

Ferner ist vorteilhaft, wenn die aktiven Lasten, der als Stromspiegel arbeitende erste Transistor im Stromspiegelzweig und die zweiten Abfangtransistoren PNP-Transitoren, und die ersten Abfangtransistoren, der zweite Transistor im Stromspiegelzweig, sowie der als Stromquelle dienende Transistor NPN-Transistoren sind.

An dieser Stelle sei vermerkt, daß alle nicht näher bezeichneten Transistoren der Multivibratorschaltung NPN-Transistoren sind.

Besonders vorteilhaft ist es ferner, wenn die Spannungsversorgungsschaltung zur Erzeugung einer Referenz- bzw. Bezugsspannung einen aus mehreren Widerständen bestehenden Widerstandteiler zur Aufteilung der Versorgungsspannung aufweist.

Die Spannung über dem ersten Widerstand dient dabei als Bezugsspannung für die Basis der ersten Abfangtransistoren der Stromsteuerschaltung und die Spannung über einen letzten Widerstand dieses Widerstandsspannungsteilers dient als Anschluß eines Spannungs-Strom-Wandlers, letztlich zur Erzeugung einer Bezugsspannung für die Stromquellen der Oszillatorschaltung und der Stromsteuerschaltung.

Hierdurch ist sichergestellt, daß die Frequenz der Oszillatorschaltung unabhängig von der Versorgungsspannung ist. Mit Ausnahme eines Widerstandes der Spannungsversorgungsschaltung kann die gesamte Schaltung monolitisch integriert realisiert werden. Der herausgeführte Widerstand kann dann zum Abgleich der Oszillatorfrequenz dienen.

Weitere bevorzugte Ausgestaltungen der erfindungsgemäßen emittergekoppelten Multivibratorschaltung ergeben sich aus den Unteransprüchen.

Ein Ausführungsbeispiel der Erfindung wird nachfolgend unter Bezugnahme auf eine Zeichnung näher erläutert.

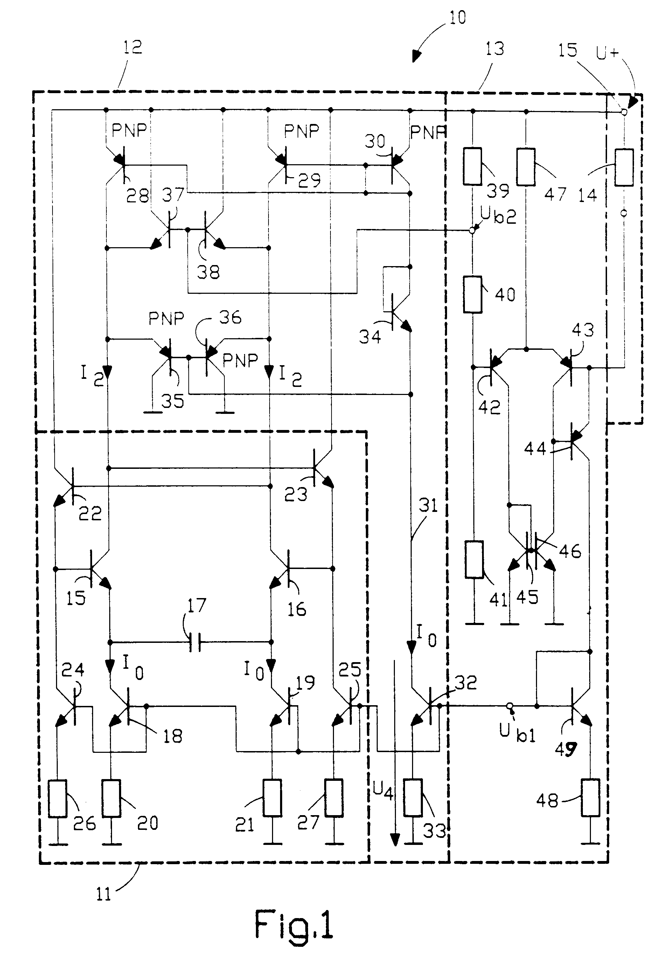

Die einzige Fig. 1 dieser Zeichnung zeigt eine erfindungsgemäße temperatur- und versorgungsspannungsunabhängige emittergekoppelte Multivibratorschaltung.

Die in Fig. 1 dargestellte erfindungsgemäße Multivibratorschaltung 10 ist im wesentlichen aus drei Teilschaltungen, nämlich einer Oszillatorschaltung 11, einer Stromsteuerschaltung 12 und einer Spannungsversorgungsschaltung 13 aufgebaut. Aus der Spannungsversorgungsschaltung 13 ist ein Widerstand 14 herausgeführt und dient u.a. für den Abgleich der Spannungsversorgungsschaltung 13. An seinem oberen Pin 15 liegt der Pluspol einer Versorgungsspannung U an. Der Widerstand 14 ist vorzugsweise so bemessen, daß er eine vernachlässigbare Temperaturdrift aufweist. Er bildet ferner einen externen Widerstand der Multivibratorschaltung 10, die beispielsweise sonst integriert ausgeführt ist.

Die Oszillatorschaltung 11 ist im Prinzip in bekannter Weise aufgebaut. Sie weist zwei Schalttransistoren 15 und 16 auf, die emitterseitig über einen Kondensator 17 verbunden sind und jeweils über eine Stromquelle aus einer Reihenschaltung eines Transistors 18 bzw. 19 und eines Widerstandes 20 bzw. 21 an Masse anliegen. Die Oszillatorschaltung 11 verfügt ferner über kreuzgekoppelte Pegelschiebetransistoren 22 und 23, die mit den Schalttransistoren 15 und 16 entsprechend verbunden sind und emitterseitig jeweils über eine Stromquelle aus einem Transistor 24 bzw. 25 und einem Widerstand 26 bzw. 27 mit Masse verbunden sind. Die jeweilige Basiselektrode des Transistors 18, 19, 24 und 25 ist mit einer Bezugsspannungsquelle $U_{b1}$ verbunden. Die Kollektoren der Pegelschiebetransistoren 22 und 23 sind beispielsweise über die Stromsteuerschaltung 12 und die Spannungsversorgungsschaltung 13 direkt mit der Versorgungsspannung U verbunden.

Um eine temperaturunabhängige Differenz $U_H$ der Schwellenspannungswerte zum Kippen der Schalttransistoren 15 bzw. 16 sicherzustellen, sind die Kollektoren der Schalttransistoren 15 und 16 in die Stromsteuerschaltung 12 hineingeführt und arbeiten dort auf aktive Lasten 28 bzw. 29. Diese aktiven Lasten 28 und 29 sind vorzugsweise als PNP-Stromquellentransistoren ausgeführt und emitterseitig an der Versorgungsspannung U angeschlossen. Der Kollektor von Schalttransistor 15 arbeitet also auf den Kollektor von Lasttransistor 28 und der Kollektor von Schalttransistor 16 auf den Kollektor von Lasttransistor 29. Zusammen mit einem Transistor 30 in einem Stromspiegelzweig 31 bilden die Lasttransistoren 28 und 29 einen Stromspiegel. Über eine Stromquelle aus einer Reihenschaltung aus einem Transistor 32 und einem Widerstand 33 im Stromspiegelzweig 31 wird ein Referenzstrom $I_o$ eingestellt. Im Stromspiegelzweig 31 liegt ferner noch ein zweiter Transistor 34, der als Diode geschaltet ist. Die Reihenschaltung aus dem ersten Transistor 30 und dem zweiten Transistor 34 des Stromspiegelzweiges 31 ergibt das Basispotential für die zweiten Abfangtransistoren 35 und 36 für einen oberen Schwellenspannungswert. Diese Abfangtransistoren 35 und 36 legen somit den oberen Wert des Spannungshubes $U_H$ an den Kollektoren der Schalttransistoren 15 und 16 der Oszillatorschaltung 11 fest. Zur Einstellung des unteren Wertes dienen die ersten Abfangtransistoren 37 und 38. Deren Basispotential wird durch eine Bezugsspannungsquelle $U_{b2}$ der Spannungsversorgungsschaltung 13 eingestellt.

Das funktionsmäßige Zusammenspiel der bisher beschriebenen Schaltungsbestandteile ist folgendes. Bei identischen Transistoren 28, 29 und 30 ergibt sich ein Strom in den Kollektoren von Transistor 28 und 29, der jeweils dem Referenzstrom $I_o$ entspricht.

Geht man zunächst davon aus, daß Schalttransistor 15 leitend und 16 gesperrt ist, so fließt durch den Schalttransistor 15 ein Strom von annähernd 2 $I_o$. Der Lasttransistor 28 liefert nur einen Strom von $I_o$, so daß der Reststrom durch einen der unteren Abfangtransistoren, nämlich Abfangtransistor 37 fließen muß. Der Abfangtransistor 37 wird somit leitend und der Abfangtransistor 35 der oberen Abfangtransistoren gesperrt. Für den gesperrt angenommenen Schalttransistor 16 ergibt sich, daß er annähernd einen Strom von Null führt. Der Kollektorstrom $I_o$ des Lasttransistors 29 fließt somit durch den Abfangtransistor 36. Der Abfangtransistor 36 wird leitend und der Abfangtransistor 38 gesperrt. Für den entgegengesetzten Fall, daß der Schalttransistor 15 sperrt und der Schalttransistor 16 leitet, gilt obiges in entsprechender Weise.

Nach der Theorie wechselt der emittergekoppelte Multivibrator seinen Schaltzustand, wenn die Schleifenverstärkung 1 beträgt. In diesem Punkt läßt sich das Stromverhältnis $z = I_o/I_2$ durch eine kubische Gleichung der folgenden Form angeben.

$$(I_o/I_2)^3 - 4 (I_o/I_2)^2 + 4 (I_o/I_2) - 1 = 0 \quad (4)$$

Hierin ist $I_2$ der Strom durch den gesperrten Schalttransistor des Multivibrators.

Von den drei mathematischen Lösungen der Gleichung (4) ist nur die folgende physikalisch sinnvoll

$$z = I_o/I_2 = (3 + \sqrt{5})/2 \quad (5)$$

Die Schwellenspannungsdifferenz $U_H$ der Schaltungsanordnung aus Oszillatorschaltung 11 und Stromsteuerschaltung 12 entspricht somit dem Ausdruck

$$U_H = 2 (U_4 - U_{b2}) +$$
$$+ 2 U_T \ln (I_o^2(1 - 1/z)^2/(z (2 - 1/z) I_{SP} I_{SN})) \quad (6)$$

Hierin ist $I_{SP}$ der Sättigungsstrom des PNP-Transistors 35 bzw. 36 und $I_{SN}$ der Sättigungsstrom des NPN-Transistors 37 bzw. 38 und Spannung $U_4$ eine Spannung über der Stromquelle im Stromspiegelzweig 31. Setzt man Gleichung (5) in Gleichung (6) ein, so erhält man folgende Gleichung:

$$U_H \approx 2 (U_4 - U_{b2}) + 2 U_T \ln (0,09 I_o^2/(I_{SP} I_{SN})) \quad (7)$$

Gleichung (7) ist noch nicht temperaturunabhängig. Dies läßt sich durch eine entgegengesetzte Temperaturabhängigkeit des Ausdruckes $U_4-U_{b2}$ erreichen. Vorteilhaft wird dies dadurch sichergestellt, daß die Emitterfläche von dem ersten Transistor 30 im Stromspiegelzweig 31 um den Faktor P größer ist als die jeweilige Emitterfläche der zweiten Abfangtransistoren 35 bzw. 36 und die Emitterfläche des zweiten Transistors 34 im Stromspiegelzweig 31 um den Faktor N größer ist als die von dem Abfangtransistor 37 bzw. 38. Für den Ausdruck $U_4 - U_{b2}$ ergeben sich die folgenden Gleichungen.

$$U_4 - U_{b2} = U - U_{BE_{30}} - U_{BE_{34}} - U_{b2} \quad (8)$$
$$U_4 - U_{b2} = U - U_{b2} - U_T \ln (I_o^2/(P N I_{SP} I_{SN})) \quad (9)$$

Durch Einsetzen von Gleichung (9) in Gleichung (7) ergibt sich:

$$U_H \approx 2 (U - U_{b2}) + 2 U_T \ln(0,09 P N) \quad (10)$$

Gleichung (10) wird temperaturunabhängig, wenn gilt:

$$P N = 1/0,09 \approx 11 \quad (10a)$$

Durch die geeignete Wahl der Emitterflächen der Transistoren 30 und 34 läßt sich somit eine Schwellenwertspannungsdifferenz $U_H$ erzeugen, die temperaturunabhängig ist.

Wie eingangs bereits ausgeführt, muß für eine driftfreie Oszillatorfrequenz nicht nur die Schwellenwertspannungsdifferenz $U_H$ temperaturunabhängig sein, sondern auch der Strom $I_o$. Hier sei angemerkt, daß die Temperaturdrift des Kondensators 17 vernachlässigbar sei.

Damit letztlich auch der Strom $I_o$ temperaturunabhängig ist, liefert die Spannungsversorgungsschaltung 13 zwei Bezugsspannungen $U_{b1}$ und $U_{b2}$. Hier sei angemerkt, daß der Widerstand 14 der Spannungsversorgungsschaltung 13 zwar angehört, jedoch nicht integriert ausgeführt ist. In der Spannungsversorgungsschaltung 13 wird die Bezugsspannung $U_{b2}$ mittels eines Widerstandsspannungsteilers aus den Widerständen 39, 40 und 41 zwischen den Widerständen 39 und 40 aus der Versorgungsspannung U gewonnen. Es gilt:

$$U_H = 2 (U - U_{b2}) \text{ mit } U_{b2} = \alpha U_1 \quad (11)$$
$$= 2 U (1 - \alpha) \quad (12)$$

Der Strom $I_o$ entsteht mittels eines Spannungs-Strom-Wandlers. Als Spannungs-Strom-Wandler dient ein gegengekoppelter Operationsverstärker, bestehend aus den Transistoren 42, 43, 44, 45 und 46 sowie dem Widerstand 47, der die Kollektoren der Transistoren 42 und 43 mit der Versorgungsspannung U verbindet. Die Basis des Transistors 42 ist zwischen den Widerständen 40 und 41 angeschlossen. Der Kollektor des Transistors 42 ist über den Transistor 45 mit Masse und mit dessen Basis verbunden, die wiederum mit der Basis des Transistors 46 verbunden ist. Der Kollektor des Transistors 43 ist über den Transistor 46 mit Masse verbunden und steuert die Basis des Transistors 44 an. Die Basis des Transistors 43 ist mit dem Widerstand 14 und über den Transistor 44 mit einem Transistor 49 verbunden, dessen Emitter über einen Widerstand 48 an Masse anliegt. Der Transistor 49 ist als Diode geschaltet. An seiner Basis steht die Bezugsspannung $U_{b1}$ zur Verfügung. Diese Spannung wird den Stromquellentransistoren 18, 19, 24, 25 und 32 basisseitig zugeführt.

Der Spannungs-Strom-Wandler übersetzt die Spannung $\alpha U$, die über den Widerständen 40 und 41 abfällt in die Referenzspannung $\beta U$, die über dem Widerstand 41 abfällt auf die Basis von Transistor 43 und hält sie, unabhängig von der Strombelastung, konstant. Der Strom $I_o$ berechnet sich somit aus:

$$I_o = (U - \beta U)/R \quad (13)$$

Hierin ist R der Widerstandswert von Widerstand 14.

Für die Schwingfrequenz f des Oszillators ergibt sich durch Einsetzen von Gleichung (12) und Gleichung (13) in Gleichung (1):

$$f = (U - \beta U)/(4 U(1 - \alpha) C R) \quad (14)$$
$$f = (1 - \beta)/(4 (1 - \alpha) C R) \quad (15)$$

Gleichung (15) ist unabhängig von der Versorgungsspannung U, so daß bei Schwingfrequenz eine temperatur- und versorgungsspannungsunabhängige emittergekoppelte Multivibratorschaltung mit wenigen Bauelementen zur Verfügung steht.

## Patentansprüche

1. Temperatur- und versorgungsspannungsunabhängige, emittergekoppelte Multivibratorschaltung, aufgebaut aus einer Oszillatorschaltung (11) mit zwei Schalttransistoren (15, 16), einer Stromsteuerschaltung (12) und einer aus einer Spannungsquelle gespeisten Spannungsversorgungsschaltung (13) für mindestens zwei Bezugsspannungen, wobei die Kollektoren der Schalttransistoren (15, 16) an je einen Kollektor-Emitterzweig von zwei ersten Abfangtransistoren (37, 38) für eine niedrigste und von zwei zweiten Abfangtransistoren (35, 36) für eine höchste, als Spannungsgrenze wirksame Schwellenspannung angeschlossen sind und auf aktive Lasten (28, 29) der Stromsteuerschaltung (12) arbeiten, welchen aktiven Lasten ein Stromspiegelzweig (31) mit einer Reihenschaltung aus mindestens zwei Transistoren (30, 34) und einer Stromquelle (32, 33) zugeordnet ist, wovon wenigstens ein zweiter der Transistoren (34) als Diode geschaltet ist, und wobei die Spannungsversorgungsschaltung (13) mindestens eine der Bezugsspannungen ($U_{b1}$, $U_{b2}$) für eine versorgungsspannungsunabhängige Schwingfrequenz (f) erzeugt,
dadurch gekennzeichnet, daß eine der Bezugsspannungen ($U_{b2}$) die ersten Abfangtransistoren (37, 38) und der Emitter des zweiten Transistors (34) im Stromspiegelzweig (31) die zweiten Abfangtransistoren (35, 36) ansteuert und daß die Emitterflächen der Abfangtransistoren (35, 36 bzw. 37, 38) paarweise in einem Verhältnis zu den Emitterflächen der Transistoren (30, 34) im Stromspiegelzweig (31) stehen.

2. Multivibratorschaltung nach Anspruch 1, dadurch gekennzeichnet, daß die Emitterfläche des zweiten Transistors (34) im Stromspiegelzweig (31) um einen Faktor N größer ist als jeder der gleichen Emitterflächen der kollektorseitig an der Versorgungsspannung U angeschlossenen ersten Abfangtransistoren (37, 38), und daß die Emitterfläche des ersten Transistors (30) im Stromspiegelzweig (31) um einen Faktor P größer ist als jede der gleichen Emitterflächen der kollektorseitig gegen Masse geschalteten zweiten Abfangtransistoren (35, 36).

3. Multivibratorschaltung nach Anspruch 2, dadurch gekennzeichnet, daß das Produkt der Faktoren N und P einem geeigneten Wert, vorzugsweise dem Wert 11 entspricht, wodurch die Temperaturunabhängigkeit eines Schwellenspannungsdifferenzwertes $U_H$ der Oszillatorschaltung (11) sichergestellt wird.

4. Multivibratorschaltung nach Anspruch 3, dadurch gekennzeichnet, daß der zweite Transistor (34) im Stromspiegelzweig (31) als Diode geschaltet ist, der erste Transistor (30) eine Basis-Kollektor-Verbindung aufweist, und die Stromquelle im Stromspiegelzweig (31) aus einer Reihenschaltung eines dritten Transistors (32) und eines ersten Widerstandes (33) aufgebaut ist, wobei der erste Widerstand (33) an Masse anliegt.

**5.** Multivibratorschaltung nach Anspruch 4, dadurch gekennzeichnet, daß in der Stromsteuerschaltung (12) die aktiven Lasten (28, 29), der Stromspiegeltransistor (30) und die zweiten Abfangtransistoren (35, 36) PNP-Transistoren, und die ersten Abfangtransistoren (37, 38), der zweite Transistor (34) sowie der dritte Transistor (32) NPN-Transistoren sind.

**6.** Multivibratorschaltung nach einem oder mehreren der vorhergehenden Ansprüche, dadurch gekennzeichnet, daß die Schalttransistoren (15, 16) emitterseitig über einen Kondensator (17) verbunden sind und über je eine Stromquelle aus einem Transistor (18 bzw. 19) und einem weiteren Widerstand (20 bzw. 21) mit Masse verbunden sind, daß mit den Schalttransistoren (15, 16) kreuzgekoppelte Pegelschiebetransistoren (22, 23) verbunden sind, deren Kollektoren mit der Versorgungsspannung U und deren Emitter an je eine Basis eines Schalttransistors (15, 16) anliegen und über je eine Stromquelle aus einem weiteren Transistor (24 bzw. 25) und einem Widerstand (26 bzw. 27) mit Masse verbunden sind, und daß eine Bezugsspannung $U_{b1}$ basisseitig die Stromquellentransistoren (18, 19, 24, 25) ansteuert.

**7.** Multivibratorschaltung nach einem oder mehreren der vorhergehenden Ansprüche, dadurch gekennzeichnet, daß die Spannungsversorgungsschaltung (13) zur Erzeugung einer Bezugsspannung an der Versorgungsspannung U einen Widerstandsspannungsteiler mit einem zweiten, dritten und vierten Widerstand aufweist, zur Erzeugung von der Bezugsspannung $U_{b2}$ zwischen dem zweiten (39) und dem dritten (40) Widerstand und zum Anschluß eines Spannungs-Strom-Wandlers zwischen dem dritten (40) und dem vierten (41) Widerstand zur Erzeugung der Bezugsspannung $U_{b1}$.

**8.** Multivibratorschaltung nach Anspruch 7, dadurch gekennzeichnet, daß als Spannungs-Strom-Wandler ein gegengekoppelter Operationsverstärker dient, der einen vierten (42) und einen fünften (43) emitterseitig verbundenen und über einen fünften Widerstand (47) an der Versorgungsspannung U angeschlossenen Transistor aufweist, die Basis des vierten Transistors (42) zwischen dem dritten (40) und dem vierten (41) Widerstand angeschlossen ist und kollektorseitig über einen sechsten Transistor (45) in Diodenschaltung an Masse anliegt und der Kollektor des fünften Transistors (43) an der Basis eines siebten Transistors (44) und über einen achten Transistor (46) an Masse anliegt, dessen Basis mit der vom sechsten Transistor (45) verbunden ist, daß die Basis des fünften Transistors (43) über einen sechsten Widerstand (14) an der Versorgungsspannung U und am Emitter des siebten Transistors (44), dessen Kollektor über einen neunten Transistor (49) und einem siebten Widerstand (48) an Masse anliegt, und daß an der Basis des neunten Transistors (49), die mit dem Kollektor verbunden ist, die Bezugsspannung $U_{b1}$ zur Verfügung steht.

**9.** Multivibratorschaltung nach Anspruch 8, dadurch gekennzeichnet, daß die Basis des neunten Transistors (49) mit jeder Basis der Stromquellentransistoren (18, 19, 24, 25) und (32) verbunden ist.

**10.** Multivibratorschaltung nach Anspruch 9, dadurch gekennzeichnet, daß über den dritten (40) und den vierten (41) Widerstand eine Spannung von $\alpha$ U und über den vierten Widerstand (41) eine Spannung $\beta$ U zur Verfügung steht, wodurch eine Schwingfrequenz für die Oszillatorschaltung (11) von $f = (1- \beta)/(4 (1- \alpha) C R_{14})$ zur Verfügung steht, die unabhängig von der Versorgungsspannung U ist, wobei C die Kapazität des Kondensators und $R_{14}$ der sechste Widerstand ist.

**11.** Multivibratorschaltung nach Anspruch 8, 9 oder 10 dadurch gekennzeichnet, daß die Oszillatorschaltung (11), die Stromsteuerschaltung (12) und die Spannungsversorgungsschaltung (13) mit Ausnahme von dem sechsten Widerstand (14) integriert realisiert sind und der sechste Widerstand (14) zum Abgleich der Oszillatorfrequenz dient und eine vernachlässigbare Temperaturdrift aufweist, ebenso wie der Kondensator (17) der Oszillatorschaltung (11).

**Claims**

**1.** A temperature and supply-voltage independent emitter-coupled multivibrator circuit comprising an oscillator circuit (11) having two switching transistors (15, 16), a current control circuit (12) and a voltage supply circuit (13), powered by a voltage source, for at least two reference voltages, the collectors of the switching transistors (15, 16) each being coupled to a collector-emitter branch of two first limiting transistors (37, 38) for a lower threshold voltage acting as a voltage limit and of two second limiting transistors (35, 36) for an upper threshold voltage acting as a voltage limit and acting upon active loads (28, 29) of the current control circuit (12), which active loads are associated with a current mirror branch (31) comprising a series arrangement of at least two transistors (30, 34) and a current source (32, 33), at least a second one of the transistors (34) being connected as a diode, and the voltage supply circuit (13) generating at least one of reference voltages ($U_{b1}$, $U_{b2}$) for a supply-voltage independent oscillation frequency (f),

characterised in that one of the reference voltages ($U_{b2}$) drives the first limiting transistors (37, 38) and the emitter of the second transistor (34) in the current mirror branch (31) drives the second limiting transistors (35, 36), and in that emitter areas of the limiting transistors (35, 36 and 37, 38 respectively) are proportioned pairwise in relation to emitter areas of the transistors (30, 34) in the current mirror branch (31).

2. A multivibrator circuit as claimed in Claim 1, characterised in that the emitter area of the second transistor (34) in the current mirror branch (31) is a factor N as large as each of the equal emitter areas of the first limiting transistors (37, 38), which are connected to the supply voltage (U) at the collector side, and in that the emitter area of the first transistor (30) in the current mirror branch (31) is a factor P as large as each of the equal emitter areas of the second limiting transistors (35, 36), which are connected to earth at the collector side.

3. A multivibrator circuit as claimed in Claim 2, characterised in that the product of the factors N and P corresponds to a suitable value, preferably the value 11, as a result of which the temperature independence of a threshold voltage difference value $U_H$ of the oscillator circuit (11) is achieved.

4. A multivibrator circuit as claimed in Claim 3, characterised in that the second transistor (34) in the current mirror branch (31) is connected as a diode, the first transistor (30) has a base-collector connection, and the current source in the current mirror branch (31) comprises a series arrangement of a third transistor (32) and a first resistor (33), the first resistor (33) being connected to earth.

5. A multivibrator circuit as claimed in Claim 4, characterised in that in the current control circuit (12) the active loads (28, 29), the current-mirror transistor (30) and the second limiting transistors (35, 36) are PNP transistors, and the first limiting transistors (37, 38), the second transistor (34) and the third transistor (32) are NPN transistors.

6. A multivibrator circuit as claimed in any one or any of the preceding Claims, characterised in that the switching transistors (15, 16) are connected at the emitter side via a capacitor (17) and are each connected to earth via a current source comprising a transistor (18 and 19, respectively) and a further resistor (20 and 21, respectively), in that cross-coupled level-shifting transistors (22, 23) are connected to the switching transistors (15, 16), whose collectors are coupled to the supply voltage (U) and whose emitters are each coupled to a base of a switching transistor (15, 16) and to earth via a current source comprising a further transistor (24 and 25, respectively) and a further resistor (26 and 27, respectively), and in that a reference voltage ($U_{b1}$) drives the current-source transistors (18, 19, 24, 25) at the base side.

7. A multivibrator circuit as claimed in any one or any of the preceding Claims, characterised in that the voltage supply circuit (13) for generating a reference voltage has a resistive voltage divider for the supply voltage (U), which divider comprises a second, a third and a fourth resistor (39, 40, 41), in order to generate the reference voltage ($U_{b2}$) between the second resistor (39) and the third resistor (40), and for connecting a voltage-to-current converter between the third resistor (40) and the fourth resistor (41) in order to generate the reference voltage ($U_{b1}$).

8. A multivibrator circuit as claimed in Claim 7, characterised in that the voltage-to-current converter is an operational amplifier with negative feedback, which comprises a fourth (42) and a fifth (43) transistor which are connected at the emitter side and which are connected to the supply voltage U via a fifth resistor (47), the base of the fourth transistor (42) is connected between the third (40) and the fourth (41) resistor and is connected to earth at the collector side via a diode-connected sixth transistor (45) and the collector of the fifth transistor (43) is connected to the base of a seventh transistor (44) and to earth via an eighth transistor (46), whose base is connected to that of the sixth transistor (45), in that the base of the fifth transistor (43) is connected to the supply voltage U via a sixth resistor (14) to the supply voltage terminal and to the emitter of the seventh transistor (44), whose collector is connected to earth via a ninth transistor (49) and a seventh resistor (48), and in that the reference voltage ($U_{b1}$) is available at the base of the ninth transistor (47), which is connected to the collector.

9. A multivibrator circuit as claimed in Claim 8, characterised in that the base of the ninth transistor (49) is connected to each base of the current source transistors (18, 19, 24, 25) and (32).

10. A multivibrator circuit as claimed in Claim 9, <u>characterised in that</u> a voltage αU is available across the third (40) and the fourth (41) resistor and a voltage βU is available across the fourth resistor (41), as a result of which an oscillation frequency which is independent of the supply voltage U is available for the oscillator circuit (11) of $f = (1-\beta)/(4 (1-\alpha) C R_{14})$, where C is the capacitance of the capacitor and $R_{14}$ is the sixth resistor.

11. A multivibrator circuit as claimed in Claim 8, 9 or 10, <u>characterised in that</u> the oscillator circuit (11), the current control circuit (12) and the voltage supply circuit (13) are integrated, except for the sixth resistor (14), and the sixth resistor (14) serves for adjusting the oscillator frequency and has a negligible temperature drift, just as the capacitor (17) of the oscillator circuit (11).

## Revendications

1. Circuit multivibrateur couplé par les émetteurs et indépendant de la température et de la tension d'alimentation, constitué d'un circuit oscillateur (11) avec deux transistors de commutation (15, 16), d'un circuit de commande de courant (12) et d'un circuit d'alimentation de tension (13) alimenté par une source de tension pour au moins deux tensions de référence, les collecteurs des transistors de commutation (15, 16) étant connectés chacun à une branche collecteur-émetteur de deux premiers transistors d'interception (37, 38) pour une tension de seuil très basse et de deux deuxièmes transistors d'interception (35, 36) pour une tension de seuil très haute opérant comme limite de tension, et travaillant sur des charges actives (28, 29) du circuit de commande de courant (12), une branche de miroir de courant (31) comprenant un montage en série d'au moins deux transistors (30, 34) et d'une source de courant (32, 33) étant affectée auxdites charges actives, au moins un deuxième des transistors (34) étant connecté en diode, et le circuit d'alimentation de tension (13) produisant au moins une des tensions de référence ($U_{b1}$, $U_{b2}$) pour une fréquence d'oscillation (f) indépendante de la tension d'alimentation, caractérisé en ce que l'une des tensions de référence ($U_{b2}$) commande les premiers transistors d'interception (37, 38) et l'émetteur du deuxième transistor (34) dans la branche de miroir de courant (31) commande les deuxièmes transistors d'interception (35, 36) et en ce que les surfaces d'émetteurs des transistors d'interception (35, 36 ou 37, 38) sont présentes par paires dans la branche de miroir de courant (31) selon un certain rapport vis-à-vis des surfaces d'émetteurs des transistors (30, 34).

2. Circuit multivibrateur selon la revendication 1, caractérisé en ce que la surface d'émetteur du deuxième transistor (34) dans la branche de miroir de courant (31) est supérieure d'un facteur N à chacune des surfaces d'émetteurs égales des premiers transistors d'interception (37, 38) connectés à la tension d'alimentation U côté collecteur, et en ce que la surface d'émetteur du premier transistor (30) de la branche de miroir de courant (31) est supérieure d'un facteur P à chacune des surfaces d'émetteurs égales des deuxièmes transistors d'interception (35, 36) mis à la masse côté collecteur.

3. Circuit multivibrateur selon la revendication 2, caractérisé en ce que le produit des facteurs N et P correspond à une valeur appropriée, de préférence à la valeur 11, si bien que l'indépendance vis-à-vis de la température d'une valeur de différence de tension de seuil $U_H$ du circuit oscillateur (11) est garantie.

4. Circuit multivibrateur selon la revendication 3, caractérisé en ce que le deuxième transistor (34) dans la branche de miroir de courant (31) est connecté en diode, le premier transistor (30) présente une liaison base-collecteur et la source de courant de la branche de miroir de courant (31) est constituée d'un montage en série d'un troisième transistor (32) et d'une première résistance (33), la première résistance (33) étant mise à la masse.

5. Circuit multivibrateur selon la revendication 4, caractérisé en ce que, dans le circuit de commande de courant (12), les charges actives (28, 29) du transistor miroir de courant (30) et les deuxièmes transistors d'interception (35, 36) sont des transistors PNP et les premiers transistors d'interception (37, 38), le deuxième transistor (34) et le troisième transistor (32) sont des transistors NPN.

6. Circuit multivibrateur selon une ou plusieurs des revendications précédentes, caractérisé en ce que les transistors de commutation (15, 16) sont reliés côté émetteur via un condensateur (17) et sont connectés à la masse, respectivement via une source de courant constituée d'un transistor (18 ou 19) et d'une autre résistance (20 ou 21), que des transistors décaleurs de niveau (22, 23) couplés en croix sont connectés aux transistors de commutation (15, 16), les collecteurs des transistors étant connectés à la tension d'alimentation U et leurs émetteurs s'appliquant respectivement à une base d'un transistor de commutation (15, 16) et étant raccordés à la masse via, respectivement, une source de courant constituée d'un autre transistor (24 ou 25) et d'une résistance (26 ou 27), et qu'une tension de référence $U_{b1}$ côté base commande les transistors sources de tension (18, 19, 24, 25).

7. Circuit multivibrateur selon une ou plusieurs des revendications précédentes, caractérisé en ce que le circuit d'alimentation de tension (13) présente, pour la production d'une tension de référence sur la tension d'alimentation U, un diviseur de tension à résistances avec une deuxième, une troisième et une quatrième résistances, pour la production de la tension de référence $U_{b2}$ entre la deuxième (39) et la troisième (40) résistances et pour la connexion d'un convertisseur tension-courant entre la troisième résistance (40) et la quatrième résistance (41) afin de produire la tension de référence $U_{b1}$.

8. Circuit multivibrateur selon la revendication 7, caractérisé en ce qu'on se sert comme convertisseur de tension-courant d'un amplificateur opérationnel à contre-réaction, qui présente un quatrième transistor (42) et un cinquième transistor (43) reliés côté émetteurs et connectés par une cinquième résistance (47) à la tension d'alimentation U, la base du quatrième transistor (42) étant raccordée entre la troisième résistance (40) et la quatrième résistance (41) et s'appliquant côté collecteur à la masse via un sixième transistor (45) connecté en diode, et le collecteur du cinquième transistor (43) s'applique à la base d'un septième transistor (44) et est mis à la masse via un huitième transistor (46), dont la base est reliée à celle du sixième transistor (45), en ce que la base du cinquième transistor (43) est appliquée via une sixième résistance (14) à la tension d'alimentation U et à l'émetteur du septième transistor (44) dont le collecteur est mis à la masse via un neuvième transistor (49) et une septième résistance (48), et en ce que, sur la base du neuvième transistor (49), qui est reliée au collecteur, la tension de référence $U_{b1}$ est disponible.

9. Circuit multivibrateur selon la revendication 8, caractérisé en ce que la base du neuvième transistor (49) est connectée à chaque base des transistors sources de courant (18, 19, 24, 25) et (32).

10. Circuit multivibrateur selon la revendication 9, caractérisé en ce que l'on dispose, via la troisième résistance (40) et la quatrième résistance (41), d'une tension $\alpha U$ et, via la quatrième résistance (41), d'une tension $\beta U$, grâce à quoi on peut disposer d'une fréquence d'oscillation pour le circuit oscillateur (11) de $f = (1 - \beta)/(1 - \alpha) \, C \, R_{14})$ qui est indépendante de la tension d'alimentation U, C étant la capacité du condensateur et $R_{14}$ la sixième résistance.

11. Circuit multivibrateur selon la revendication 8, 9 ou 10, caractérisé en ce que le circuit oscillateur (11), le circuit de commande de courant (12) et le circuit d'alimentation de tension (13) sont intégrés à l'exception de la sixième résistance (14) et la sixième résistance (14) sert à équilibrer la fréquence d'oscillation et présente une dérive thermique insignifiante, tout comme le condensateur (17) du circuit oscillateur (11).

Fig.1